# EUROPÄISCHE PATENTANMELDUNG

(11) **EP 1 429 384 A1**
(43) Veröffentlichungstag der Anmeldung: **16.06.2004**
(21) Anmeldenummer: 03027137.3
(22) Anmeldetag: 26.11.2003
(51) Int. Cl.: H01L 23/051, H01L 23/48

(54) **Schaltungsanordnung für Halbleiterbauelemente und Verfahren zur Herstellung**

(30) Priorität: 14.12.2002 DE 10258565
(71) Anmelder: Semikron Elektronik GmbH Patentabteilung, 90253 Nürnberg (DE)
(72) Erfinder: Heilbronner, Heinrich, Dr., 90547 Stein (DE)

(57) **Zusammenfassung**

Die Erfindung beschreibt eine Schaltungsanordnung zur Kontaktierung von Halbleiterbauelementen (30), speziell Leistungshalbleiterbauelementen, miteinander und oder mit zugeordneten Anschlussleitern (10,11). Die Schaltungsanordnung besteht aus mindestens zwei Anschlussleitern (10,11), mindestens zwei Halbleiterbauelementen (30) sowie mindestens einem Isolierstoffkörper (20). Hierbei ist an dem ersten Anschlussleiter (10) der Isolierstoffkörper (20) angeordnet, welcher eine Mehrzahl von Durchkontaktierungen (21) aufweist, die aus einem mit elektrisch sowie thermisch leitfähigen Werkstoff verfüllten Durchbrüchen bestehen. An der zweiten Seite des Isolierstoffkörpers (20) ist mindestens ein Halbleiterbauelement (30) angeordnet, wovon mindestens eine Kontaktfläche (32) mittels der Durchkontaktierungen (21) des Isolierstoffkörpers mit dem ersten Anschlussleiter (10) verbunden ist. Die Kontaktfläche (32) des Halbleiterbauelements (30) ist mit dem ersten Anschlussleiter somit elektrisch und thermisch leitend verbunden. Die der Kontaktfläche (32) gegenüberliegende Hauptfläche des Halbleiterbauelements ist mit dem zweiten Anschlussleiter elektrisch und thermisch leitend verbunden. Die im Betrieb innerhalb der Leistungshalbleiterbauelemente entstehende Wärme kann dadurch von beiden Hauptflächen des Halbleiterbauelements abgeführt werden.

## Beschreibung

Die Erfindung beschreibt eine Schaltungsanordnung und ein Verfahren zu deren Herstellung zur Kontaktierung von Halbleiterbauelementen, speziell Leistungshalbleiterbauelementen wie Transistoren, Thyristoren oder Dioden, miteinander und / oder mit zugeordneten Anschlussleitern. Derartige Schaltungsanordnungen finden beispielhaft als Leistungshalbleitermodule Verwendung. Derartige Leistungshalbleitermodule als auch in der Leistungselektronik wohl bekannte Scheibenzellen bilden daher den Ausgangspunkt der Erfindung, die sich allerdings nicht ausschließlich auf o.g. Anwendungen beschränkt.

Zum Stand der Technik zählen Scheibenzellen, die nach dem Stand der Technik aus einem Isolierstoffkörper bestehen, der die seitliche Umhausung darstellt, sowie einem davon umschlossenen Verbund bestehend aus einem Halbleiterkörper sowie diesem zugeordnet einer Mehrzahl flächiger metallischer Kontaktkörper. Die Ober- sowie die Unterseite sind ebenfalls als flächige Kontaktkörper ausgebildet und dienen der Stromzu- bzw. Stromabführung. Derartige Scheibenzellen haben den Vorteil mechanisch sehr robust zu sein. Weiterhin ist vorteilhaft, dass die durch die Verlustleistung des Halbleiterbauelements entstehende Wärme über beide Kontaktkörper der Ober- und Unterseite und somit in zwei Richtungen abgeführt werden kann.

Nachteilig an Scheibenzellen ist hingegen ihr einer automatisierten Fertigung nur schwer zugänglicher Aufbau, der eine Vielzahl einzeln zueinander zu justierender Elemente aufweist. Weiterhin sind derartige Schaltungsanordnungen nur für ein Halbleiterbauelement pro Gehäuse sinnvoll.

Ebenfalls zum Stand der Technik zählen Leistungshalbleitermodule, wie sie aus der DE 196 51 632 C2 bekannt sind. Derartig Leistungshalbleitermodule weisen ein Mehrzahl von Halbleiterbauelementen innerhalb eines gemeinsamen Gehäuses auf, wobei Anschlusselemente zum Anschluss mehrerer Halbleiterbauelemente dienen können. Vorteilhaft hierbei ist die Integration und schaltungsgerechte Verbindung der Mehrzahl von Halbleiterbauelementen, die eine einfachere Anwendung im Vergleich zum diskreten, beispielhaft mittels Scheibenzellen realisierten, Aufbauten erlauben.

Nachteilig an derartigen Leistungshalbleitermodulen ist, dass die die sichere elektrische Verbindung der Halbleiterbauelemente mit den Anschlusselementen herstellenden Druckkontaktierungen für jedes Halbleiterbauelement getrennt ausgeführt sein müssen.

Die DE 101 21 970 A1 beschreibt eine sehr moderne Variante eines Leistungshalbleitermoduls, wie es beispielhaft in der EP 0 750 345 A2 gezeigt ist, bei welchem die nach dem Stand der Technik üblichen Drahtbondverbindungen durch eine flexible Leiterplatte in Verbindung mit einem elastischen Druckkörper ersetzt werden. Derartig Leistungshalbleitermodule, deren Substrat meist direkt auf einem Kühlkörper angeordnet ist weisen den Vorteil einer elektrischen Isolierung zum Kühlköper mittels ihres Substrats auf. Weiterhin vorteilhaft ist die durch die flexible Leiterplatte gegebene Möglichkeit einer nahezu wahlfreien Verschaltung innerhalb der Leistungshalbleitermoduls.

Nachteilig hierbei ist, dass die Wärmeabfuhr, die durch die Durchlassverluste der Halbleiterbauelemente entsteht, durch zwei Faktoren eingeschränkt ist. Einerseits kann die Wärme nur in eine Richtung, an den Kühlkörper, abgegeben werden und anderseits wird diese Abgabe der Wärme durch den Isolierstoffkörper, der Teil des Substrates ist gehemmt.

Der vorliegenden Erfindung liegt die Aufgabe zu Grunde eine Schaltungsanordnung, und ein Verfahren zu deren Herstellung, für mindestens zwei Halbleiterbauelemente vorzustellen, wobei die Wärmeabführung von den Halbleiterbauelementen verbessert wird sowie gleichzeitig der Montageaufwand für diese Schaltungsanordnung verringert wird.

Diese Aufgabe wird gelöst durch eine Schaltungsanordnung nach dem Anspruch 1, sowie ein Verfahren nach Anspruch 2, spezielle Ausgestaltungen finden sich in den Unteransprüchen.

Der grundlegende Gedanke der Erfindung ist eine Schaltungsanordnung sowie ein Verfahren zu deren Herstellung vorzustellen, die aus mindestens zwei Anschlussleitern, mindestens zwei Halbleiterbauelementen sowie mindestens einem Isolierstoffkörper besteht. Hierbei ist an der zweiten Hauptfläche des ersten Anschlussleiters die erste Hauptfläche eines Isolierstoffkörper angeordnet ist, der eine Mehrzahl von Durchkontaktierungen aufweist, die aus einem mit elektrisch sowie thermisch leitfähigen Werkstoff verfüllten Durchbrüchen dieses Isolierstoffkörpers bestehen. An der zweiten Hauptfläche des Isolierstoffkörpers ist mindestens ein Halbleiterbauelement derart angeordnet, dass mindestens eine Kontaktfläche des Halbleiterbauelements mittels der Durchkontaktierungen des Isolierstoffkörpers mit dem ersten Anschlussleiter verbunden ist. Die zweite Hauptfläche des Halbleiterbauelements ist stoffbündig oder stoffschlüssig oder mittels eines weiteren Isolierstoffkörpers auf dem zweiten Anschlussleiter angeordnet. Die mindestens eine Kontaktfläche der zweiten Hauptfläche des Halbleiterbauelements ist mit Kontaktstellen der ersten Oberfläche des zweiten Isolierstoffkörper elektrisch und thermisch leitend verbunden. Die im Betrieb innerhalb der Leistungshalbleiterbauelemente entstehende Wärme kann somit mittels der Durchkontaktierungen und / oder durch den Anschlussleiter von beiden Hauptflächen abgeführt werden.

Bei der Herstellung derartiger Schaltungsanordnungen wird in einem ersten Schritt mindestens ein Halbleiterbauelemente auf mindestens einem Isolierstoffkörper mittels eines adhäsiven Verfahrens angeordnet. Vorteilhafterweise, um eine effektives Herstellungsverfahren zu ermöglichen, werden alle Halbleiterbauelemente auf einem Isolierstoffkörper angeordnet. Im weiteren wird dieser Verbund auf dem zweiten Anschlussleiter, anschließend der erste Anschlussleiter angeordnet. Anschießend wird der gesamte Verbund mit Druck beaufschlagt um die sichere elektrische und thermische Verbindung herzustellen.

Vorteilhaft ist weiterhin den adhäsiven Werkstoff zur Verbindung des Isolierstoffkörpers mit den Halbleiterbauelementen ausschließlich an Stellen des Isolierstoffkörpers anzuordnen, die keine Durchkontaktierungen aufweisen. Somit ist eine sichere, niederohmige Verbindung zum Halbleiterbauelement hergestellt, da der adhäsive Werkstoff den Stromfluss nicht beeinträchtigen kann.

Die Erfindung wird anhand der Ausführungsbeispiele in Verbindung mit den Fig. 1 bis 4 näher erläutert.
- Fig. 1: zeigt eine erste Ausgestaltung der erfinderischen Schaltungsanordnung für eine Diode und einen Transistor.
- Fig. 2: zeigt eine weitere Ausgestaltung der erfinderischen Schaltungsanordnung für Halbleiterbauelemente unterschiedlicher Bauhöhe.
- Fig. 3: zeigt eine weitere Ausgestaltung der erfinderischen Schaltungsanordnung mit zwei Isolierstoffkörpern.
- Fig. 4: zeigt eine erfinderisch Schaltungsanordnung in Halbbrückentopologie.

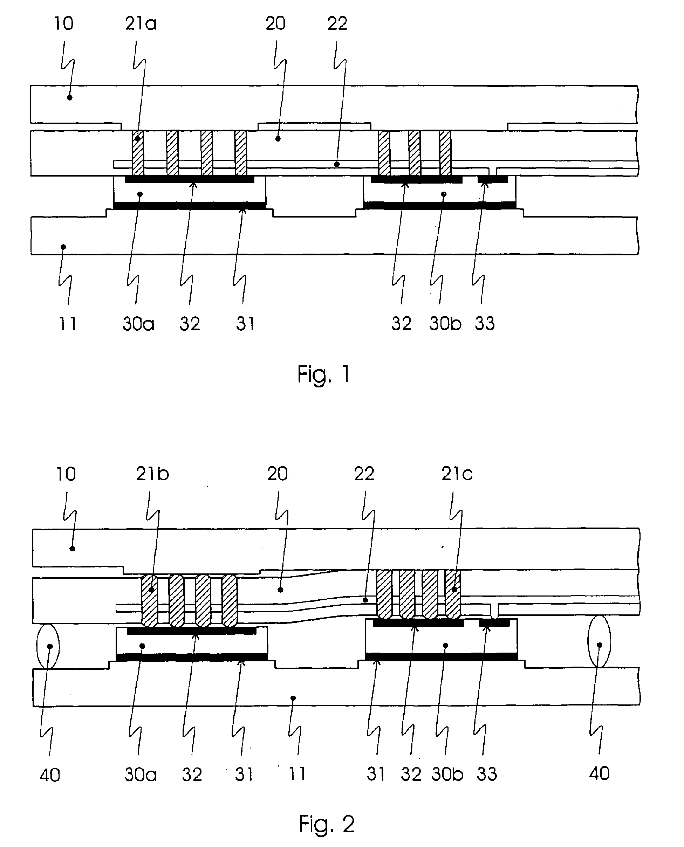

Fig. 1 zeigt eine Schaltungsanordnung in Druckkontaktierung für je eine Diode (30a) und einen Transistor (30b). Diese ist selbstverständlich, beispielhaft in Richtung der Zeichenebene, erweiterbar auf eine Mehrzahl von Dioden und / oder Transistoren. Die Schaltungsanordnung besteht aus einem zweiten metallische Anschlussleiter, beispielhaft aus vernickeltem Kupfer, (11). Dieser weist plane Erhebungen zu Anordnung der Halbleiterbauelemente (30) auf. Auf der dem zweiten Anschlussleiter (11) abgewandten Seite der Halbleiterbauelemente ist ein Isolierstoffkörper (20) angeordnet. Dieser Isolierstoffkörper (20) besteht aus einem dauerelastischen Kunststoff, einem Elastomer. Innerhalb dieses Isolierstoffkörper angeordnet ist eine metallische Leiterbahn (22), welche zur Verbindung der Kontaktfläche (33), dem Gatepad des Transistors, mit einem externen Anschluss dient. Weiterhin weist der Isolierstoffkörper (20) metallische Durchkontaktierungen (21), bestehend aus einer Zinn- Silber- Legierung, auf. Auf der den Halbleiterbauelementen (30) abgewandten Seite des Isolierstoffkörpers ist ein erster Anschlussleiter (10) aus dem gleichen Werkstoff wie der zweite Anschlussleiter (11) angeordnet, der ebenfalls plane Erhebungen an den, den Erhebung des zweiten Anschlussleiters gegenüberliegenden, Stellen, aufweist. Diese planen Stellen sind über die Durchkontaktierungen (21 a) mit den zugeordneten Kontaktflächen (32) der Halbleiterbauelemente elektrisch leitend verbunden. Eine nicht dargestellte Schraubverbindung der beiden Anschlussleiter beaufschlagt die gesamte Schaltungsanordnung mit Druck, um ein sicher elektrische und thermische Kontaktierung der Halbleiterbauelemente zum zweiten Anschlussleiter (11) sowie zu den Durchkontaktierungen (21) des Isolierstoffkörpers (20) als auch der Durchkontaktierungen zum ersten Anschlussleiter (10) sowie der Kontaktierung der Leiterbahn (22) zum Gatepad (33) des Halbleiterbauelements (30b) herzustellen.

Die sichere elektrische Kontaktierung erfolgt hier, indem durch die Druckkontaktierung der Isolierstoffkörper soweit komprimiert wird, dass die Durchkontaktierungen sicheren flächigen Kontakt mit den Halbleiterbauelemente bzw. dem ersten Anschlussleiter aufweisen.

Das bevorzugte Herstellungsverfahren dieser Schaltungsanordnung weist folgend grundlegende Verarbeitungsschritte auf:
- Herstellung eines Isolierstoffkörpers mit einer darin angeordneten Leiterbahn (22) sowie den Durchkontaktierungen (21).
- Aufbringen eines adhäsiven Werkstoffes, hier eines niedrig viskosen Klebstoffes, mit einer Schichtdicke von weniger als 0,1 mm, auf der den Halbleiterbauelemente (30) zugewandten Seite des Isolierstoffkörpers (20) wobei die Durchkontaktierungen (21) nicht mit Klebstoff benetzt werden.
- Positionierung der Halbleiterbauelement (30) auf dem Isolierstoffkörper (20). Durch den Klebstoff wird somit aus dem Isolierstoffkörper und den Halbleiterbauelementen ein Verbund, der als ganzes weiterverarbeitet werden kann.
- Aufbringen des Verbundes aus Halbleiterbauelementen und Isolierstoffkörper auf dem zweiten Anschlussleiter (11).
- Anordnen des ersten Anschlussleiters (10)
- Druckbeaufschlagung der Anschlussleiter zur Komprimierung des dazwischen angeordneten Isolierstoffkörpers (20) und damit sicheren Kontaktierung der ebenfalls dazwischen angeordneten Halbleiterbauelemente (30).

Fig. 2 zeigt eine weitere Ausgestaltung der erfinderischen Schaltungsanordnung für Halbleiterbauelemente unterschiedlicher Bauhöhe. Hierbei weist, unter sonst gleichen Bedingungen wie unter Fig. 1 beschrieben der erste Anschlussleiter (10) auf der dem Transistor (30b) zugewandten Seite keine plane Erhebung auf. Die größere Bauhöhe des Transistors wird somit ausgeglichen.

Die Durchkontaktierungen (21 b) dieser Ausgestaltung weisen an einer (21 c) oder beiden (21 b) Stirnseiten warzenartige Erhebungen auf. Dies Ausgestaltung erweist sich als vorteilhaft, wenn der Klebstoff zur Fixierung der Halbleiterbauelemente flächig auf dem Isolierstoffkörper aufgebracht wird. Mittels der Warzen kann bei Druckbeaufschlagung der Klebstoff an den Kontaktflächen zum Halbleiterbauelement verdrängt werden und somit eine niederohmiger Kontakt hergestellt werden. Die Warzen erweisen sich auch als vorteilhaft, falls die Schaltungsanordnung zum Zweck der inneren Isolierung mit einem Isolierstoff, wie beispielhaft einem Silikonkautschuk verfüllt wird. Hierzu erweisen sich Dichtelemente (40) am Rand als vorteilhaft, um ein Austreten des Silikonkautschuks vor der Polymerisierung zu verhindern.

Sollten alle Durchkontaktierungen beidseits die oben beschriebenen Warzen aufweisen, so kann als Werkstoff des Isolierstoffkörpers auch ein Duroplast verwendet werden, da hier keine Kompression des Isolierkörpers notwendig ist um den sicheren elektrischen und thermischen Kontakt herzustellen.

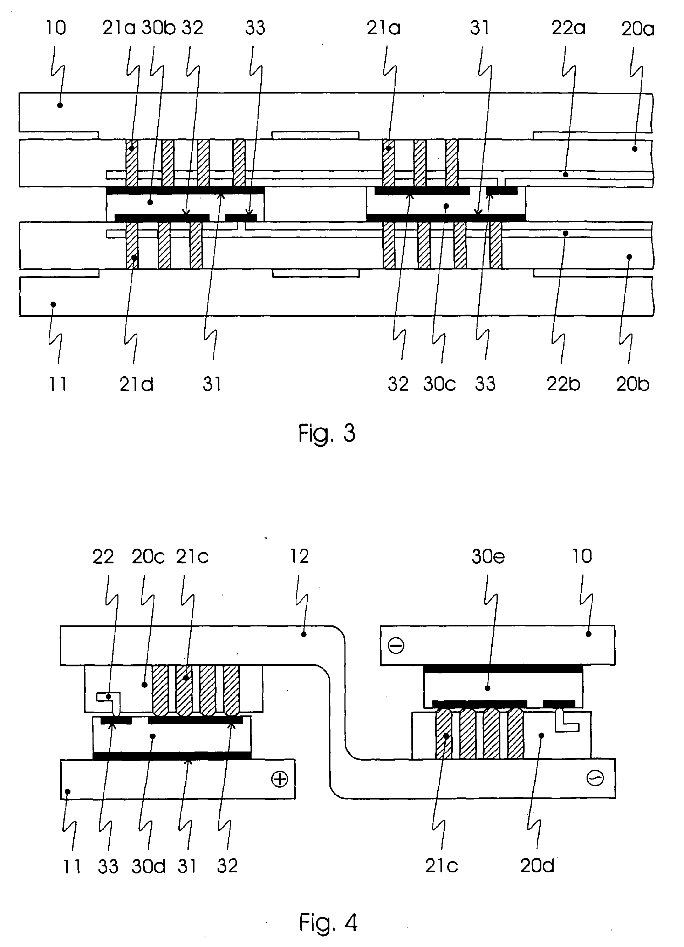

Fig. 3 zeigt eine weitere Ausgestaltung der erfinderischen Schaltungsanordnung mit zwei Isolierstoffkörpern (20). Falls die funktionsgerechte Schaltung es notwendig macht, wird eine weitere Verbindungsebene in Form eines weiteren Isolierstoffkörpers (20b) Bestandteil der Schaltungsanordnung. Es entsteht somit ein symmetrischer Aufbau der Schaltungsanordnung, wobei auf dem ersten Anschlussleiter (10) ein Isolierstoffkörper (20a) angeordnet ist, auf dessen zweiter Hauptfläche die Halbleiterbauelemente (30) angeordnet sind und diese mittels eines zwischen diesen und dem zweiten Anschlussleiter (11) angeordneten zweiten Isolierstoffkörper (20b) mit dem Anschlussleiter (11) verbunden sind.

Die Isolierstoffkörper sind wie unter Fig. 1 beschrieben aufgebaut. Das erste Halbleiterbauelement (30b), ein Transistor, vorzugsweise ein IGBT (insulated gate bipolar transistor) ist kollektorseitig (31) mittels der Durchkontaktierungen (21 a) des ersten Isolierstoffkörpers (20a) mit dem ersten Anschlussleiter (10) verbunden. Der Emitter (31) des ersten Transistors (30b) ist mittels der Durchkontaktierungen (21 d) mit dem zweiten Anschlussleiter verbunden. Das Gate (33) des ersten Transistors (30b) ist mittels der Leiterbahn (22b), welche innerhalb des zweiten Isolierstoffkörpers (20b) angeordnet ist mit einem externen Anschluss verbunden.

In analoger Weise ist der Kollektor (31) des zweiten Transistors (30c) mittels der Durchkontaktierungen des zweiten Isolierstoffkörpers mit dem zweiten Anschlussleiter verbunden. Der Emitter (32) ist mittels der Durchkontaktierungen des ersten Isolierstoffkörpers mit dem ersten Anschlussleiter verbunden. Dieser erste Isolierstoffkörper (20a) weist ebenfalls eine Leiterbahn (22a) zur Kontaktierung des Gates (33) des zweiten Transistors (30c) auf.

Die sicher elektrische und thermische Kontaktierung wird wiederum über eine Druckbeaufschlagung der gesamten Schaltungsanordnung hergestellt. Das Herstellungsverfahren gemäß Beschreibung Fig. 1 kann dahingehend abgewandelt werden, dass das erste Halbleiterbauelement auf dem ersten Isolierstoffkörper fixiert wird, das zweite Halbleiterbauelement auf dem zweiten Isolierstoffkörper fixiert wird. Anschließend wird der erste Verbund auf dem zweiten Anschlussleiter angeordnet, sowie in einem weiteren Schritt der zweite Verbund und anschließend der erste Anschlussleiter angeordnet und die gesamte Schaltungsanordnung druckbeaufschlagt.

Fig. 4 zeigt eine erfinderisch Schaltungsanordnung in Halbrückentopologie. Diese Schaltungsanordnung unterscheidet sich von den bisherigen Ausführungsbeispielen durch einen dritten Anschlussleiter (12). Der erste mit dem Pluspol eines Zwischenkreises verbundene Halbleiterschalter (30d) ist auf dem zweiten Anschlussleiter (11) angeordnet. Hierzu ist der Kollektor (31) des Transistors (30d) sowie die Kathode einer nicht gezeichneten antiparallel geschalteten Diode direkt auf dem zweiten Anschlussleiter (11) angeordnet. Der Emitter (32) des Transistors (30d) sowie die Anode der nicht gezeichneten Diode sind mittels der Durchkontaktierungen (21 c) des ersten Isolierstoffkörpers (20c) mit dem dritten Anschlussleiter (12), dem Wechselstromanschluss verbunden.

Der zweite mit dem Minuspol eines Zwischenkreises verbundene Halbleiterschalter (30e) ist auf dem ersten Anschlussleiter (10) angeordnet. Hierzu ist der Kollektor (31) des Transistors (30e) sowie die Kathode einer nicht gezeichneten Diode direkt auf dem ersten Anschlussleiter (10) angeordnet. Der Emitter (32) des Transistors (30e) sowie die Anode der nicht gezeichneten Diode sind mittels der Durchkontaktierungen (21 c) des zweiten Isolierstoffkörpers (20d) mit dem dritten Anschlussleiter (12), dem Wechselstromanschluss verbunden.

Durch die beschriebene Konfiguration wird eine Halbbrückentopologie der Schaltungsanordnung erreicht.

## Patentansprüche

1. Schaltungsanordnung bestehend aus mindestens zwei Anschlussleitern (10, 11, 12), mindestens zwei Halbleiterbauelementen (30) sowie mindestens einem Isolierstoffkörper (20),
wobei an der zweiten Hauptfläche des ersten Anschlussleiters (10) die erste Hauptfläche eines Isolierstoffkörper (20) angeordnet ist, der eine Mehrzahl von Durchkontaktierungen (21) aufweist, die aus einem mit elektrisch sowie thermisch leitfähigen Werkstoff verfüllten Durchbrüchen dieses Isolierstoffkörpers (20) bestehen,
an der zweiten Hauptfläche des Isolierstoffkörpers (20) mindestens ein Halbleiterbauelement (30) derart angeordnet ist, dass mindestens eine Kontaktfläche (32) des Halbleiterbauelements (30) mittels der Durchkontaktierungen (21) des Isolierstoffkörpers (20) mit dem ersten Anschlussleiter (10) verbunden ist,
die zweite Hauptfläche des Halbleiterbauelements (30) stoffbündig oder stoffschlüssig oder mittels eines weiteren Isolierstoffkörpers (20) auf dem zweiten Anschlussleiter (11) angeordnet ist und,
wobei die mindestens eine Kontaktfläche (31) der zweiten Hauptfläche des Halbleiterbauelements (30) mit Kontaktstellen der ersten Oberfläche des zweiten Isolierstoffkörper (11) elektrisch und thermisch leitend verbunden ist.

2. Verfahren zu Herstellung einer Schaltungsanordnung nach Anspruch 1, wobei mindestens ein Halbleiterbauelemente (30) auf mindestens einem Isolierstoffkörper (20) mittels eines adhäsiven Verfahrens angeordnet ist, dieser Verbund anschließend auf dem zweiten Anschlussleiter (11) aufgeordnet wird, anschließend der erste Anschlussleiter (10) angeordnet wird und der gesamte Verbund mit Druck beaufschlagt wird um die sichere elektrische Verbindung sicherzustellen.

3. Verfahren nach Anspruch 2, wobei
der adhäsive Werkstoff ausschließlich an Stellen des Isolierstoffkörpers (10) angeordnet ist, der keine Durchkontaktierungen (21) aufweist, um eine sichere, niederohmige Verbindung zum Halbleiterbauelement (30) sicherzustellen.

4. Verfahren nach Anspruch 2, wobei
die Verbindung zwischen den Halbleiterbauelementen (30)und den Anschlussleitern (10, 11) stoffbündig oder stoffschlüssig ist.

5. Schaltungsanordnung nach Anspruch 1 wobei
mindestens ein Halbleiterbauelement (30) mindestens eine weitere Kontaktfläche (33) aufweist und diese Kontaktfläche mit einer Leiterbahn (22), die innerhalb oder auf einer Hauptfläche eines Isolierstoffkörpers (20) angeordnet ist verbunden ist.

6. Schaltungsanordnung nach Anspruch 1 wobei
die Durchkontaktierung (21) an mindestens einer Stirnseite Warzen aufweist

7. Schaltungsanordnung nach Anspruch 1 wobei
der Isolierstoffkörper (20) in sich flexibel und / oder komprimierbar ausgestaltet ist
